# EUROPEAN PATENT SPECIFICATION

(11) **EP 0 313 650 B1**
(45) Date of publication and mention of the grant of the patent: **15.02.1995**
(21) Application number: 88905262.7
(22) Date of filing: 19.04.1988
(51) Int. Cl.: H01P 1/22, H03F 1/32, H03F 3/21, H03F 3/60, H03G 11/04, H04B 7/185

(54) **MICROWAVE ABSORBER ATTENUATOR FOR LINEAR SSPA POWER CONTROL**
ABSORBIERENDES MIKROWELLEN-DÄMPFUNGSGLIED ZUR LEISTUNGSREGELUNG EINES LINEAREN FESTKÖRPERLEISTUNGSVERSTÄRKERS
ATTENUATEUR ABSORBEUR DE MICRO-ONDES POUR COMMANDE DE PUISSANCE LINEAIRE D'AMPLIFICATEUR DE PUISSANCE A SEMI-CONDUCTEURS

(30) Priority: 04.05.1987 US 45414
(43) Date of publication of application: 03.05.1989
(60) Divisional application: 93202600.8
(73) Proprietor: AT&T Corp., New York, NY 10013-2412 (US)
(72) Inventor: MCGANN, William, E., Satellite Beach, FL 32927 (US); TODD, John, R., Palm Bay, FL 32905 (US)
(74) Representative: Watts, Christopher Malcolm Kelway, Dr.
(86) International application number: US8801311
(87) International publication number: WO8809064

(56) References cited:
- US-A- 2 898 561
- US-A- 2 981 907
- US-A- 3 624 534
- US-A- 3 842 292
- US-A- 4 485 349

## Description

### FIELD OF THE INVENTION

The present invention relates in general to satellite communication systems, and is particularly directed to a scheme for controlling the output power of a microwave solid state power amplifier through the use of ferrite absorber element, the insertion of which into a section of output waveguide is adjustable.

### BACKGROUND OF THE INVENTION

Because of its low cost and compact size, the solid state (GaAs) power amplifier (SSPA) is a commonly employed component of the uplink transmitter of a VSAT (very small aperture terminal) Ku band earth station. The (gain) transfer (power output vs. power input) characteristic of a typical SSPA has a positive sloped linear region which gradually decreases over a knee portion to a slightly negative-sloped saturation region. When drive at the 1.0dB gain compression point, namely at that point on the knee of the transfer characteristic which is 1dB below an extension of its linear, positive slope region, the frequency response of the SSPA has a substantially smooth profile over its intended operational range.

For currently available SSPAs the output power at the 1dB gain compression point is on the order of two watts, which may be considerably greater than the power required by the link (e.g. one watt). Consequently, it is necessary to reduce the output power transmitted by the uplink terminal. Ideally, this power reduction would be accomplished by simply reducing the input power to the SSPA, as its output linearly tracks its input over the linear portion of its transfer characteristic below the 1dB compression point. Unfortunately, the frequency response of the SSPA does not follow suit. Instead, the frequency response drastically departs from the smooth flat profile at 1dB compression and ripples significantly across the transmit passband.

In copending U.S. Patent Application entitled "Power Control System for VSAT Earth Station", by William E. McGann, filed September 15, 1986, U.S. Serial No. 907,009, assigned to the Assignee of the present application, and the disclosure of which is hereby incorporated into the present application by reference, there is described a signal processing scheme for compensating for this nonlinear frequency response and additional performance variables (e.g. gain vs. temperature) which essentially comprises a preemphasis mechanism inserted upstream of the SSPA. Now, while the nonlinearity compensation scheme described in that application is certainly a useful technique for solving the nonlinearity problem, it would be preferred, if possible, to operate the SSPA in such a manner to avoid the problem altogether.

US-A-4485349 discloses a method as set out in the preamble of claim 1. The output level of the network is monitored and maintained at a preset level by means of a feedback loop which controls an attenuator in a temperature compensated preamplifier.

### SUMMARY OF THE INVENTION

Pursuant to the present invention, the objective discussed above is achieved by effectively operating the SSPA at the 1dB compression point, where the passband ripple does not exist, and controllably reducing, downstream of the SSPA, the power output produced by the SSPA to the level required by the link. In particular, the present invention is directed to a mechanism for controllably inserting a relatively thin tapered blade of ferrite material into a waveguide coupling section downstream of the SSPA. Preferably the ferrite material is comprised of epoxy-bonded carbonyl steel particles of sufficient thickness to withstand the heat induced in the course of its absorbing microwave energy at the SSPA output, while being of a narrow or thin configuration and oriented for insertion into the absorbing section of waveguide so as to not effectively alter the characteristics of the signal profile of the electromagnetic wave.

### BRIEF DESCRIPTION OF THE DRAWINGS

Figure 1 is a diagrammatic illustration of a VSAT power amplifier section incorporating a waveguide attenuator in accordance with the present invention;
Figures 2 and 3 are respective sectional side and end views of the attenuator waveguide section 14 shown in Figure 1 depicting the manner in which the attenuator element is inserted into the waveguide section; and
Figure 4 is a cross-sectional view of the attenuator element 33 employed in the attenuator waveguide section shown in Figures 2 and 3.

### DETAILED DESCRIPTION

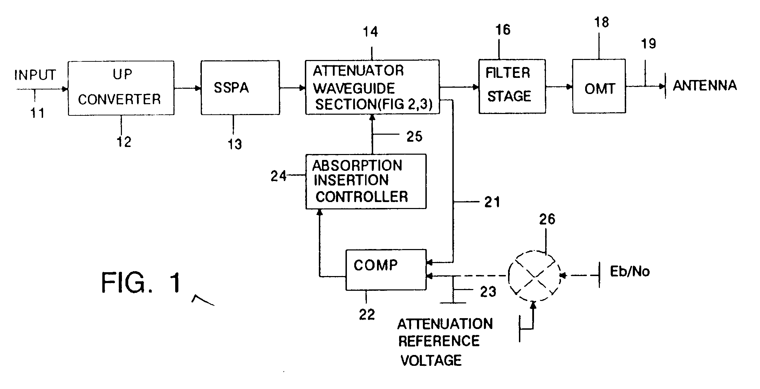

Referring now to Figure 1, there is illustrated a schematic block diagram of a power control section containing a solid-state power amplifier and attenuator waveguide section incorporated in the up-converter circuitry between the IF input and RF output of a VSAT earth station.

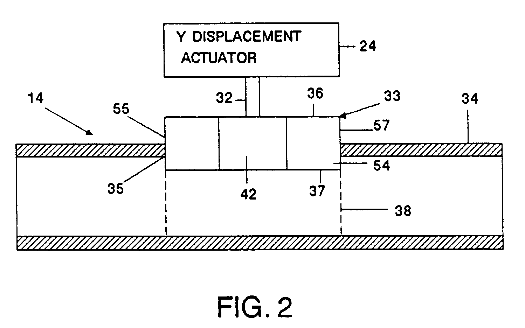

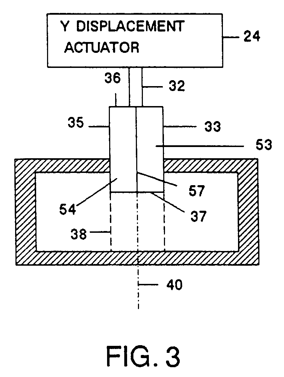

More specifically, an input signal (e.g. an intermediate frequency signal having a frequency of 140MHz) is coupled to an up-converter 12 of the earth station transmitter. The output of up-converter 12 has a frequency corresponding to the transmission frequency of the earth terminal, as beamed from the earth terminal antenna to the satellite. For purposes of the present description, it will be assumed that this output frequency lies in a Ku band range of 14.0-14.5GHz. The up-converter 12 is coupled to a solid state power amplifier (SSPA) 13, the output of which is coupled to an attenuator waveguide section 14, the details of which will be described below in conjunction with the description of Figures 2 and 3. Attenuator waveguide section 14 serves to controllably attenuate the output of SSPA 13 to the level required by the satellite link. As mentioned briefly above, SSPA 13 is operated at its 1dB gain compression point so that its frequency response is substantially flat over the range of frequencies of interest (e.g. 14.0-14.5GHz).

The output of waveguide section 14 is coupled through a waveguide filter stage 16 to an orthomode transducer 18. Waveguide filter stage 16 is comprised of a pair of cascaded filters, specifically a harmonic output rejection filter for SSPA 13 and a receive band noise power rejection filter. The output of orthomode transducer 18 is coupled over link 19 to an antenna feedhorn (not shown).

As mentioned above, the behavioral characteristics of a typical SSPA 13 are such that its gain varies considerably with a change in frequency when operated below its 1dB gain compression point. Pursuant to the present invention, SSPA 13 is operated at its 1dB gain compression point so that its output characteristic is substantially flat over the frequency range of interest. For present day VSAT stations, operating in the Ku band, the output power of the terminal may be on the order of several watts or less. (Typically, for a commercially available gallium arsenide SSPA, its 1dB gain compression point produces an output on the order of two watts.) The power required by the satellite link can be expected to be between one and two watts, so that the output of the SSPA must be reduced. Pursuant to the present invention, rather than reduce the input to the SSPA, which would certainly reduce its output, but would do so by driving the operational state of the SSPA to a gain level that results in a very nonlinear frequency response, the present invention operates the SSPA at a gain where its frequency response is substantially flat (for example at its 1dB gain compression point) and attenuates the substantially full power output level of the SSPA.

For this purpose, as shown in Figure 1, the output of attenuator waveguide section 14 is coupled over link 21 to a comparator 22. A second input of comparator 22 is coupled over link 23 to an attenuation reference voltage, corresponding to the desired power level on the satellite output link.

Such an attenuation reference voltage may be derived directly from a manually set voltage source or from a voltage combining circuit (e.g. summing circuit), shown in broken lines at 26 in Figure 1, the output of which represents the sum or (or difference between) the manually set voltage and one or more monitored system parameters, such as a signal representative of E_{b}/Nₒ used for uplink power control for compensating for a reduction in signal level (e.g. rain fade at the local site). The difference between the actual output produced by attenuator section 14 and the desired level produces a signal at the output of comparator 22 which is supplied to an attenuator insertion controller 24. Attenuator insertion controller 24 is essentially comprised of a linear DC actuator which controls the insertion of a ferrite attenuator element to be described below into waveguide section 14.

More particularly, with reference to Figures 2 and 3, attenuator waveguide section 14 is shown as comprising a rectangular waveguide 34 having a slot 35 at the top thereof which is sized to accommodate a tapered ferrite attenuator element 33. Element 33 is coupled to one end of the output displacement arm of linear DC actuator 24, shown diagrammatically at 32 in Figures 2 and 3. As mentioned above, linear actuator 24 displaces its output arm 32 in accordance with the differential signal supplied at the output of comparator 22. The displacement of output arm 32 and, consequently, the degree of insertion of attenuator element 33 through slot 35 in waveguide 34 controls the degree of absorption of the 14.5-15.0GHz electromagnetic wave travelling through the waveguide. For maximum absorption control, slot 35 is preferably situated in a direction parallel with the longitudinal axis (the z axis) of the waveguide and symmetrical about a center line 40 of the waveguide. The attenuator element itself is preferably comprised of a microwave absorber material that offers both strength and heat dissipation robustness with respect to the electromagnetic energy which is coupled through the waveguide section 34.

For this purpose, element 33 may comprise a tapered blade of magnetically loaded epoxide, such as ECCOSORB MF materials manufactured by Emerson and Cuming. For purposes of the present embodiment, it may be assumed that ECCOSORB MF 117 type material may be employed as absorber element 33.

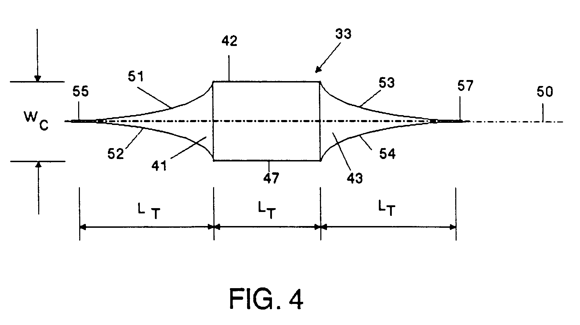

As shown in the cross-sectional view of Figure 4, the physical configuration of the absorber element is such that it is symmetrically tapered at regions 41 and 43 about a vertical plane line 50 which is intended to be coincident with the center line 40 of waveguide section 14 when the absorber is inserted into slot 35 at the top of the waveguide shown in Figures 2 and 3. Region 41 has a pair of tapered faces 51 and 52 which extend from a pair of parallel sidewalls 46 and 47 and taper to a point 55 at one end of the absorber. At the other end of the absorber, region 43, which is contiguous with a central region 42 of the absorber, has a pair of tapering side faces 53 and 54 which extend to an edge 57. For minimizing the VSWR, the tapering of faces 51-54 follows a Tschebyscheff binomial taper. The length L_{T} of regions 41 and 43 and the length of L_{C} of central region 42 between tapered regions 41 and 43, as well as the width or thickness W_{C} of central region 42 of absorber blade 33, depends upon the size of the waveguide, the frequency of the energy being absorbed, the degree of absorption to be obtained, any external cooling that may be supplied, etc. For purposes of the present description, for providing a variable degree of absorption of up to 15dB of signals in the frequency range of interest (14.5-15.0GHz), the dimensions may lie in the following ranges: 0≦L_{T}≦0.750; 0≦L_{C}≦0.500; 0≦W_{C}≦0.050, where the material is ECCOSORB MF 117.

Because the leading and trailing edges 55 and 57, respectively, of the absorber blade 33 are narrowed to a point and the absorber is tapered away from those edges towards its thickness in the central region of the absorber, the electromagnetic wave travelling through the waveguide does not abruptly encounter the absorber material, thereby minimizing its effect on the voltage standing wave ratio.

As shown in Figures 2 and 3, the top and bottom surfaces 36 and 37 of absorber 33 are substantially parallel to the top and bottom surfaces of the waveguide 34, the separation between which corresponds to the interior height or b dimension of the waveguide 34. Thus, maximum absorption is provided when the absorber 33 is inserted fully into the waveguide and extends from the top interior surface of the waveguide to the bottom interior surface thereof as delineated by broken lines 38 in Figures 2 and 3. For the parametric values recited here, it has been found that the absorber can provide approximately 100dB of absorption capability when fully inserted into the waveguide. However, in practical use, the range of absorption is on the order of 0-15dB, to provide the transmitter output power levels mentioned previously.

To form an individual absorber element, a sheet or bar of the absorber material, such as the ECCOSORB MF series of material, manufactured by Emerson & Cuming, may be individually cut and machined to provide the requisite cross-section. Preferably, however, the absorber material, which basically comprises a steel carbonyl microsphere paste, is formed into the prescribed state of molding. This permits the absorber blade element to be inexpensively mass-produced.

Advantageously, the absorber configuration of the present invention is a cost effective alternative to the look-up table frequency response correction scheme for correcting for the nonlinearity of the operation of the SSPA as described in the above-referenced copending application. The present invention may be incorporated into the system described in that application and, in so doing, the monitor and control processor and associated memory through which the frequency response correction is carried out can be eliminated. Specifically, the present invention is inserted at the downstream end of the SSPA, as shown in Figure 1, while the temperature correction and down link AGC correction networks are retained at the upstream end of the link. The SSPA is operated at its 1dB compression point to obtain the essentially flat frequency response characteristic.

Controlled insertion of the absorber element into a section of slotted waveguide thereby offers a simple and relatively inexpensive mechanical expedient to the electronically implemented look-up table tracking procedure of the system described in the foregoing application. When combined with the temperature controlled network and downlink AGC correction circuitry, the present invention equips the VSAT with a cost effective power control mechanism for simplifying adjustment of SSPA output power. For maximizing utility of the control network, accordingly, it is preferred that the temperature control and AGC downlink control portions of the system described in the copending application, which form an upstream input controller to the SSPA, be combined with the downstream attenuator absorber mechanism of the present invention.

## Claims

1. A method of operating a signal amplification network through which input signals to be transmitted over a communication link are coupled, said network including a signal amplification device (13) the output power characteristic of which is substantially flat over the frequency range of operation of said amplification device for a first output level of said amplifier, but is substantially nonlinear over said frequency range for a second output level of said amplification device
CHARACTERISED BY
(a) operating said signal amplification device such that the signal output level thereof corresponds to said first output level; and
(b) adjusting the level of the signal output produced by said signal amplification device to said second output level, by coupling the output of said amplification device through a section of waveguide downstream thereof and controllably inserting a microwave absorber into said section of waveguide so as to reduce the signal output level to a level less than said first output level.

2. A method according to claim 1, wherein step (b) comprises adjusting the level of the signal output produced by said signal amplification device in accordance with a variation in one or more prescribed operational characteristics of said communication link.

3. A method according to claim 1 or claim 2, wherein said signal amplificiation device comprises a solid state power amplifier.

4. A method according to any of the preceding claims wherein said microwave absorber comprises a body of material having tapered leading and trailing surfaces (51-54) extending in the direction of transmission of microwave signals through said section of waveguide.

5. A method according to claim 4, wherein said tapered surfaces taper to leading and trailing edges of said absorber such that microwave signals travelling through said section of waveguide gradually encounter the bulk of the material of said absorber.

6. A method according to any of the preceding claims, wherein said absorber is controllably inserted into a slot (35) in said section of waveguide whereat the magnitude of the electric field vector is at a maximum.

7. A method according to any of the preceding claims, further including the steps of
(c) storing information representative of the variation in the manner in which said signal amplification network couples signals therethrough over a range of variation of at least one prescribed operating parameter; and
(d) modifying input signals coupled to said signal amplification device in accordance with information stored in step (c).

8. A method according to claim 7, wherein the information stored in step (c) is representative of the variation in gain of said signal amplification network for variations in ambient temperature thereof, and step (d) comprises controllably adjusting said input signals as a complementary function of said variation of gain with temperature.

9. An arrangement for operating a signal amplification network through which input signals to be transmitted over a communication link are coupled, said network including a signal amplification device (13) the output power characteristic of which is substantially flat over the frequency range of operation of said amplification device for a first output level of said amplifier, but is substantially nonlinear over said frequency range for a second output level of said amplification device
CHARACTERISED BY
first means for operating said signal amplification device such that the signal output level thereof corresponds to said first output level at which the frequency response thereof has said first characteristic; and
second means (14,21-26), coupled to the output of said signal amplification device, for adjusting the level of the signal output produced by said signal amplification device to said second output level, including a section of waveguide to which output of said amplification device is coupled, a microwave absorber element insertable into said section of waveguide and means for controllably inserting said microwave absorber element into said section of waveguide to reduce the signal output level to a level less than said first output level.

10. An arrangement according to claim 9, wherein said second means comprises means for adjusting the level of the signal output produced by said signal amplification device in accordance with a variation in a prescribed operational characteristic of said communication link.

11. An arrangement according to claim 9 or claim 10, wherein said device comprises a solid state power amplifier (13).

12. An arrangement according to any of claims 9 to 11, wherein said microwave absorber comprises a body of material having tapered leading and trailing surfaces (51-54) extending in the direction of transmission of microwave signals through said section of waveguide.

13. An arrangement according to claim 12, wherein said tapered surfaces taper to leading and trailing edges of said absorber such that microwave signals travelling through said section of waveguide gradually encounter the bulk of the material of said absorber.

14. An arrangement according to any of claims 9 to 13, wherein said second means includes means for inserting said absorber into a slot (35) in said section of waveguide whereat the magnitude of the electric field vector is at a maximum.

15. An arrangement according to any of claims 9 to 14, further including
third means for storing information representative of the variation in the manner in which said signal amplification network couples signals therethrough over a range of variation of at least one prescribed operating parameter; and
fourth means for modifying input signals coupled to said signal amplification device in accordance with information stored by said third means.

16. An arrangement according to claim 15, wherein the information stored by said third means is representative of the variation in gain of said signal amplification network for variation in ambient temperature thereof, and said fourth means comprises means for controllably adjusting said input signals as a complementary function of said variation of gain with temperature.

## Patentansprüche

1. Verfahren zum Betreiben eines Signalverstärkungsnetzes, durch das über eine Kommunikationsstrecke zu übertragende Eingangssignale durchgekoppelt werden, wobei das besagte Netz eine Signalverstärkungsvorrichtung (13) enthält, deren Ausgangsleistungskennlinie über den Betriebsfrequenzbereich der besagten Verstärkungsvorrichtung für einen ersten Ausgangspegel des besagten Verstärkers im wesentlichen gerade verläuft, aber über den besagten Frequenzbereich für einen zweiten Ausgangspegel der besagten Verstärkungsvorrichtung im wesentlichen nichtlinear verläuft, gekennzeichnet durch
(a) Betreiben der besagten Signalverstärkungsvorrichtung auf solche Weise, daß deren Signalausgangspegel dem besagten ersten Ausgangspegel entspricht; und
(b) Einstellen des Pegels des von der besagten Signalverstärkungsvorrichtung erzeugten Ausgangssignals auf den besagten zweiten Ausgangspegel durch Durchkoppeln der Ausgabe der besagten Verstärkungsvorrichtung durch einen stromabwärts davon liegenden Wellenleiterteil und steuerbares Einfügen eines Mikrowellendämpfungsgliedes in den besagten Wellenleiterteil, um den Signalausgangspegel auf einen geringeren Pegel als den besagten ersten Ausgangspegel zu reduzieren.

2. Verfahren nach Anspruch 1, in dem Schritt (b) das Einstellen des Pegels des von der besagten Signalverstärkungsvorrichtung erzeugten Ausgangssignals entsprechend einer Veränderung einer oder mehrerer vorgeschriebener Betriebsmerkmale der besagten Kommunikationsstrecke umfaßt.

3. Verfahren nach Anspruch 1 oder Anspruch 2, in dem die besagte Signalverstärkungsvorrichtung einen Festkörperleistungsverstärker umfaßt.

4. Verfahren nach einem der vorhergehenden Ansprüche, in dem das besagte Mikrowellendämpfungsglied einen Körper aus Material mit sich verjüngenden Vorder- und Hinterflächen (51-54) umfaßt, die sich in Richtung der Übertragung von Mikrowellensignalen durch den besagten Wellenleiterteil erstrecken.

5. Verfahren nach Anspruch 4, in dem die besagten sich verjüngenden Flächen sich so zu den Vorder- und Hinterkanten des besagten Dämpfungsgliedes hin verjüngen, daß den besagten Wellenleiterteil durchlaufende Mikrowellensignale nach und nach auf die Masse des Material des besagten Dämpfungsgliedes stoßen.

6. Verfahren nach einem der vorhergehenden Ansprüche, in dem das besagte Dämpfungsglied steuerbar in einen Schlitz (35) im besagten Wellenleiterteil eingefügt wird, an dem die Größe des elektrischen Feldvektors auf einem Maximum ist.

7. Verfahren nach einem der vorhergehenden Ansprüche, weiterhin mit folgenden Schritten:
(c) Speichern von Informationen, die die Veränderung der Art und Weise, auf die das besagte Signalverstärkungsnetz Signale über einen Veränderungsbereich mindestens eines vorgeschriebenen Betriebsparameters hindurchkoppelt, darstellen; und
(d) Verändern von an die besagte Signalverstärkungsvorrichtung angekoppelten Eingangssignalen entsprechend der in Schritt (c) gespeicherten Informationen.

8. Verfahren nach Anspruch 7, in dem die in Schritt (c) gespeicherten Informationen die Veränderung der Verstärkung des besagten Signalverstärkungsnetzes bei Veränderungen der Umgebungstemperatur desselben darstellen und Schritt (d) das steuerbare Einstellen der besagten Eingangssignale als Komplementär funktion der besagten Verstärkungsveränderung mit der Temperatur umfaßt.

9. Anordnung zum Betreiben eines Signalverstärkungsnetzes, durch das über eine Kommunikationsstrecke zu übertragende Eingangssignale durchgekoppelt werden, wobei das besagte Netz eine Signalverstärkungsvorrichtung (13) enthält, deren Ausgangsleistungskennlinie über den Betriebsfrequenzbereich der besagten Verstärkungsvorrichtung für einen ersten Ausgangspegel des besagten Verstärkers im wesentlichen gerade verläuft, aber über den besagten Frequenzbereich für einen zweiten Ausgangspegel der besagten Verstärkungsvorrichtung im wesentlichen nichtlinear verläuft, gekennzeichnet durch
ein erstes Mittel zum Betreiben der besagten Signalverstärkungsvorrichtung, so daß deren Signalausgangspegel dem besagten ersten Ausgangspegel, auf dem deren Frequenzgang die besagte erste Kennlinie aufweist, entspricht; und
ein zweites, an den Ausgang der besagten Signalverstärkungsvorrichtung angekoppeltes Mittel (14, 21-26) zum Einstellen des Pegels des von der besagten Signalverstärkungsvorrichtung erzeugten Ausgangssignals auf den besagten zweiten Ausgangspegel, mit einem Wellenleiterteil, an den der Ausgang der besagten Verstärkungsvorrichtung angekoppelt ist, einem Mikrowellendämpfungs-glied, das in den besagten Wellenleiterteil einfügbar ist, und Mitteln zum steuerbaren Einfügen des besagten Mikrowellendämpfungsgliedes in den besagten Wellenleiterteil zum Reduzieren des Signalausgangspegels auf einen geringeren Pegel als der besagte erste Ausgangspegel.

10. Anordnung nach Anspruch 9, wobei das besagte zweite Mittel Mittel zum Verstellen des Pegels des von der besagten Signalverstärkungsvorrichtung erzeugten Ausgangssignals entsprechend einer Veränderung eines vorgeschriebenen Betriebsmerkmals der besagten Kommunikationsstrecke umfaßt.

11. Anordnung nach Anspruch 9 oder Anspruch 10, wobei die besagte Vorrichtung einen Festkörperleistungsverstärker (13) umfaßt.

12. Anordnung nach einem der Ansprüche 9 bis 11, wobei das besagte Mikrowellendämpfungsglied einen Körper aus Material mit sich verjüngenden Vorder- und Hinterflächen (51-54) umfaßt, die sich in der Übertragungsrichtung von Mikrowellensignalen durch den besagten Wellenleiterteil erstrecken.

13. Anordnung nach Anspruch 12, wobei die besagten sich verjüngenden Oberflächen sich so hin Vorder- und Hinterkanten des besagten Dämpfungsgliedes zu verjüngen, daß den besagten Wellenleiterteil durchlaufende Mikrowellensignale nach und nach auf die Masse des Materials des besagten Dämpfungsgliedes stoßen.

14. Anordnung nach einem der Ansprüche 9 bis 13, wobei das besagte zweite Mittel Mittel zum Einfügen des besagten Dämpfungsgliedes in einen Schlitz (35) im besagten Wellenleiterteil enthält, an dem die Größe des elektrischen Feldvektors auf einem Maximum ist.

15. Anordnung nach einem der Ansprüche 9 bis 14, weiterhin mit einem dritten Mittel zum Speichern von Informationen, die die Veränderung der Art und Weise, auf die das besagte Signalverstärkungsnetz Signale durch dieses hindurch über einen Veränderungsbereich von mindestens einem vorgeschriebenen Betriebsparameter durchkoppelt, darstellen; und
einem vierten Mittel zum Abändern von an die besagte Signalverstärkungsvorrichtung angekoppelten Signalen entsprechend vom besagten dritten Mittel gespeicherten Informationen.

16. Anordnung nach Anspruch 15, wobei die vom besagten dritten Mittel gespeicherten Informationen die Verstärkungsveränderung des besagten Signalverstärkungsnetzes für eine Veränderung von dessen Umgebungstemperatur darstellen und das besagte vierte Mittel Mittel zum steuerbaren Einstellen der besagten Eingangssignale als Komplementärfunktion der besagten Verstärkungsveränderung mit der Temperatur umfaßt.

## Revendications

1. Procédé de conduite d'un réseau d'amplification de signaux à travers lequel des signaux d'entrée devant être transmis sur une liaison de télécommunications sont couplés, ledit réseau comprenant un dispositif d'amplification de signaux (13) dont la caractéristique de puissance de sortie est sensiblement plate sur la gamme de fréquences de fonctionnement dudit dispositif d'amplification pour un premier niveau de sortie dudit amplificateur, mais est sensiblement non linéaire sur ladite gamme de fréquences pour un second niveau de sortie dudit dispositif d'amplification, caractérisé par :
(a) la conduite du dispositif d'amplification de signaux, de telle sorte que son niveau de sortie de signaux corresponde audit premier niveau de sortie, et
(b) l'ajustement du niveau de la sortie de signaux produite par ledit dispositif d'amplification de signaux audit second niveau de sortie, par couplage de la sortie dudit dispositif d'amplification à travers une section de guide d'ondes située en aval et par insertion réglable d'un absorbeur de micro-ondes dans ladite section de guide d'ondes de manière à réduire le niveau de sortie de signaux à un niveau inférieur audit premier niveau de sortie.

2. Procédé selon la revendication 1, dans lequel l'étape (b) comprend l'ajustement du niveau de la sortie de signaux produite par ledit dispositif d'amplification de signaux en fonction d'une variation d'une ou de plusieurs caractéristiques de fonctionnement prescrites de ladite liaison de télécommunications.

3. Procédé selon la revendication 1 ou 2, dans lequel ledit dispositif d'amplification de signaux comprend un amplificateur de puissance à semi-conducteurs.

4. Procédé selon l'une quelconque des revendications précédentes, dans lequel ledit absorbeur de micro-ondes comprend un corps d'une matière présentant des surfaces avant et arrière allant en s'effilant (51-54) s'étendant dans la direction de transmission de signaux micro-ondes à travers ladite section de guide d'ondes.

5. Procédé selon la revendication 4, dans lequel lesdites surfaces allant en s'effilant se terminent dans des bords avant et arrière dudit absorbeur, de sorte que des signaux micro-ondes progressant à travers ladite section de guide d'ondes rencontrent graduellement la masse de la matière dudit absorbeur.

6. Procédé selon l'une quelconque des revendications précédentes, dans lequel ledit absorbeur est inséré de manière réglable dans une fente (35) ménagée dans ladite section de guide d'ondes là où l'amplitude du vecteur de champ électrique est maximale.

7. Procédé selon l'une quelconque des revendications précédentes, comprenant, en outre, les étapes consistant à :
(c) stocker des informations représentatives de la variation de la manière selon laquelle le réseau d'amplification de signaux couple des signaux le traversant sur une gamme de variations d'au moins un paramètre de fonctionnement prescrit, et
(d) modifier des signaux d'entrée couplés audit dispositif d'amplification de signaux en fonction de l'information stockée dans l'étape (c).

8. Procédé selon la revendication 7, dans lequel l'information stockée dans l'étape (c) est représentative de la variation en gain dudit réseau d'amplification de signaux pour des variations de sa température ambiante, et dans lequel l'étape (d) comprend l'ajustement réglable desdits signaux d'entrée en tant que fonction complémentaire de ladite variation du gain avec la température.

9. Agencement de conduite d'un réseau d'amplification de signaux à travers lequel des signaux d'entrée devant être transmis sur une liaison de télécommunications sont couplés, ledit réseau comprenant un dispositif d'amplification de signaux (13) dont la caractéristique de puissance de sortie est sensiblement plate sur la gamme de fréquences de fonctionnement dudit dispositif d'amplification pour un premier niveau de sortie dudit amplificateur, mais est sensiblement non linéaire sur ladite gamme de fréquences pour un second niveau de sortie dudit dispositif d'amplification, caractérisé par des premiers moyens de conduite dudit dispositif d'amplification de signaux, de telle sorte que son niveau de sortie des signaux corresponde audit premier niveau de sortie auquel sa réponse en fréquence présente ladite première caractéristique, et
des deuxièmes moyens (14, 21-26), couplés à la sortie dudit dispositif d'amplification de signaux, destinés à ajuster le niveau de la sortie de signaux produite par ledit dispositif d'amplification de signaux audit second niveau de sortie, comprenant une section de guide d'ondes à laquelle est couplée la sortie dudit dispositif d'amplification, un élément absorbeur de micro-ondes pouvant être inséré dans ladite section de guide d'ondes et des moyens pour insérer de façon réglable ledit élément absorbeur de micro-ondes dans ladite section de guide d'ondes afin de réduire le niveau de sortie de signaux jusqu'à un niveau inférieur audit premier niveau de sortie.

10. Agencement selon la revendication 9, dans lequel lesdits deuxièmes moyens comprennent des moyens destinés à ajuster le niveau de la sortie de signaux produite par ledit dispositif d'amplification de signaux en fonction d'une variation d'une caractéristique de fonctionnement prescrite de ladite liaison de télécommunications.

11. Agencement selon la revendication 9 ou 10, dans lequel ledit dispositif comprend un amplificateur de puissance à semi-conducteurs (13).

12. Agencement selon l'une quelconque des revendications 9 à 11, dans lequel ledit absorbeur de micro-ondes comprend un corps d'une matière présentant des surfaces avant et arrière allant en s'effilant (51-54) s'étendant dans la direction de transmission des signaux de micro-ondes à travers ladite section de guide d'ondes.

13. Agencement selon la revendication 12, dans lequel lesdites surfaces allant en s'effilant se terminent dans des bords avant et arrière dudit absorbeur, de sorte que des signaux micro-ondes progressant à travers ladite section de guide d'ondes rencontrent graduellement la masse de la matière dudit absorbeur.

14. Agencement selon l'une quelconque des revendications 9 à 13, dans lequel lesdits deuxièmes moyens comprennent des moyens destinés à insérer ledit absorbeur dans une fente (35) ménagée dans ladite section de guide d'ondes là où l'amplitude du vecteur de champ électrique est maximale.

15. Agencement selon l'une quelconque des revendications 9 à 14, comprenant, en outre, des troisièmes moyens destinés à stocker des informations représentatives de la variation de la manière selon laquelle ledit réseau d'amplification de signaux couple des signaux le traversant sur une gamme de variations d'au moins un paramètre de fonctionnement spécifié, et
des quatrièmes moyens destinés à modifier des signaux d'entrée couplés audit dispositif d'amplification de signaux en fonction de l'information stockée par lesdits troisièmes moyens.

16. Agencement selon la revendication 15, dans lequel l'information stockée par lesdits troisièmes moyens est représentative de la variation en gain dudit réseau d'amplification de signaux pour une variation de sa température ambiante, et lesdits quatrièmes moyens comprennent des moyens destinés à ajuster de façon réglable lesdits signaux d'entrée en tant que fonction complémentaire de ladite variation du gain avec la température.
